# FASCICULE DE BREVET EUROPEEN

(11) **EP 2 952 472 B1**
(45) Date de publication et mention de la délivrance du brevet: **17.05.2017**
(21) Numéro de dépôt: 15170146.3
(22) Date de dépôt: 01.06.2015
(51) Int. Cl.: B81C 1/00

(54) **PROCEDE DE REALISATION AMELIORE D'ELEMENTS SUSPENDUS D'EPAISSEURS DIFFERENTES POUR STRUCTURE MEMS ET NEMS**
VERBESSERTES HERSTELLUNGSVERFAHREN VON HÄNGEELEMENTEN UNTERSCHIEDLICHER DICKE FÜR MEMS- UND NEMS-STRUKTUR
IMPROVED METHOD FOR THE PRODUCTION OF SUSPENDED ELEMENTS WITH DIFFERENT THICKNESSES FOR MEMS AND NEMS STRUCTURE

(30) Priorité: 05.06.2014 FR 1455107
(43) Date de publication de la demande: 09.12.2015
(73) Titulaire: Commissariat à l'Énergie Atomique et aux Énergies Alternatives, 75015 Paris (FR)
(72) Inventeur: Berthelot, Audrey, 38330 ST ISMIER (FR)
(74) Mandataire: Brevalex

(56) Documents cités:
- WO-A1-2009/072704
- WO-A2-2007/004119

## Description

### DOMAINE TECHNIQUE ET ART ANTÉRIEUR

La présente invention se rapporte à un procédé de réalisation d'une structure dotée d'au moins une partie active présentant des zones d'épaisseurs différentes. Cette structure peut être mise en oeuvre dans le cadre de la fabrication de systèmes micro-électromécaniques (MEMS pour "microelectromechanical systems" selon la terminologie anglo-saxonne, les MEMS incluant les MOEMS pour « Micro-Opto-Electro-Mechanical Systems ») et/ou de systèmes nano-électromécaniques (NEMS pour "nano-electromechanical systems" selon la terminologie anglo-saxonne, les NEMS incluant Les NOEMS pour « Nano-Opto-Electro-Mechanical Systems ») pour réaliser par exemple des capteurs et/ou des actionneurs.

Les dispositifs MEMS et NEMS peuvent être dotés d'une partie fixe et d'au moins une partie suspendue par rapport à la partie fixe, la partie suspendue étant généralement appelée "partie active" et apte à se déplacer et/ou se déformer sous l'effet d'une action extérieure, par exemple une action mécanique, et/ou électrique, et/ou magnétique. Ce déplacement peut permettre par exemple d'effectuer une détection d'une accélération, d'une rotation.

Actuellement, il existe certains capteurs formés d'une partie active comportant des éléments suspendus d'épaisseurs différentes : un premier élément, en particulier de type NEMS réalisé dans une couche d'épaisseur par exemple de l'ordre de plusieurs centaines de nanomètres peut être destiné par exemple à former une jauge de contrainte, tandis qu'un deuxième élément suspendu, en particulier MEMS, typiquement d'une épaisseur de plusieurs dizaines de micromètres, peut être destiné par exemple à former une masse d'inertie.

Le document « M&NEMS : a new approach for ultra low cost 3D inertial sensor », de P. Robert et al., IEEE Sensors 2009 conf., 25-28- Oct 2009 propose un

Le document EP 2 599 746 A1 propose une variante de procédé pour réaliser des structures MEMS&NEMS à partir d'un substrat massif encore appelé couramment « bulk ».

Dans les procédés décrits dans ces documents, le premier élément suspendu et le deuxième élément suspendu sont au moins partiellement formés dans une couche réalisée par croissance par épitaxie.

Or l'épitaxie peut s'avérer une étape longue et couteuse qui nécessite l'utilisation d'équipements spécifiques. Par ailleurs, l'épaisseur des couches qu'il est possible d'obtenir par épitaxie est généralement limitée.

Le document EP 2 599 745 A1 propose un mode de réalisation permettant de réaliser des structures MEMS&NEMS sans faire appel à une épitaxie.

Dans ce mode de réalisation, la définition de l'élément suspendu de plus faible épaisseur comprend la réalisation de tranchées puis une gravure sous une zone de la couche superficielle du substrat massif située entre les tranchées pour faire rejoindre ces tranchées et libérer cette zone formant l'élément suspendu.

Un inconvénient de cette méthode réside dans le manque de contrôle précis de la géométrie de l'élément suspendu. Le document WO2007/004119 décrit également un procédé d'une structure comportant un élément suspendu.

Il se pose le problème de trouver un procédé de réalisation d'une structure dotée d'une partie active comportant des éléments suspendus d'épaisseurs différentes et qui ne présente pas les inconvénients ci-dessus, et en particulier qui ne nécessite pas une étape d'épitaxie pour réaliser les éléments suspendus et permettre une définition précise des éléments suspendus.

### EXPOSÉ DE L'INVENTION

Ainsi, l'invention concerne un procédé de réalisation d'une structure comportant une partie active comprenant au moins un premier élément suspendu et un deuxième élément suspendu d'épaisseurs différentes,
le procédé comprenant des étapes de :
- formation dans un premier substrat d'une première zone sacrificielle,
- report, sur une première face du premier substrat, d'une couche donnée s'étendant sur la première zone sacrificielle,
- définition dans ladite couche donnée d'au moins un premier élément suspendu en regard de la première zone sacrificielle, la définition du premier élément comprenant la formation d'une ou plusieurs premières tranchées ayant un fond dévoilant la première zone sacrificielle.
- définition d'au moins un deuxième élément suspendu par formation d'une ou plusieurs deuxièmes tranchées dans le premier substrat et à travers ladite couche donnée, le deuxième élément suspendu ayant ainsi une épaisseur e₂ supérieure à l'épaisseur e₁ du premier élément suspendu,
- libération du premier élément suspendu, cette libération comprenant le retrait de la première zone sacrificielle.

Ainsi, par report de la couche donnée sur le premier substrat, on peut éviter une épitaxie pour former le premier élément suspendu et le deuxième élément suspendu.

La première zone sacrificielle peut servir de zone d'arrêt de gravure lors de la définition du premier élément dans la couche donnée. Cela peut permettre de définir précisément le premier élément.

La première zone sacrificielle n'est ici retirée qu'après avoir défini le premier élément et le deuxième élément suspendu.

Cette première zone sacrificielle peut également servir de zone de protection du premier élément suspendu lors de définition du deuxième élément suspendu, en particulier lorsque cette définition est réalisée par gravure à travers une deuxième face du premier substrat opposée à la première face.

La formation de la zone sacrificielle peut comprendre la réalisation d'au moins un trou à travers une première face du premier substrat puis un remplissage du trou par un premier matériau.

Le procédé peut comprendre en outre après formation de la première zone sacrificielle, une étape consistant à reporter un deuxième substrat sur le premier substrat. Ce report est effectué soit sur la deuxième face du premier substrat, soit sur la couche donnée.

Selon une première possibilité de mise en oeuvre du procédé, on réalise dans cet ordre préalablement à la définition du deuxième élément suspendu : le report de la couche donnée sur le premier substrat, puis la définition du premier élément suspendu dans ladite couche donnée, puis le report du deuxième substrat sur le premier substrat.

Dans ce cas, après la définition du premier élément suspendu dans ladite couche donnée et le report du deuxième substrat sur le premier substrat, on effectue un remplissage des premières tranchées par un matériau appelé « matériau sacrificiel », les premières tranchées remplies du matériau sacrificiel formant une autre zone sacrificielle disposée autour du premier élément.

La libération du premier élément comprend dans ce cas également le retrait de cette autre zone sacrificielle.

Avantageusement, le matériau sacrificiel peut être le même que celui de la première zone sacrificielle. Cela facilite la libération finale du premier élément suspendu.

Selon une deuxième possibilité de mise en oeuvre du procédé, on réalise
dans cet ordre l'étape consistant à reporter le deuxième substrat sur le premier substrat, puis l'étape consistant à reporter ladite couche donnée sur le premier substrat, puis l'étape consistant à définir le premier élément suspendu dans ladite couche donnée.

Le deuxième substrat peut être assemblé au premier substrat par le biais d'une couche de liaison comportant au moins une portion appelée deuxième zone sacrificielle disposée en regard du premier élément suspendu et d'une région du premier substrat dans laquelle le deuxième élément suspendu est réalisé ou destiné à être réalisé.

Dans ce cas, la libération du premier élément suspendu peut comprendre un retrait de la deuxième zone sacrificielle. Ce retrait peut également permettre de libérer le deuxième élément suspendu.

La première zone sacrificielle et la deuxième zone sacrificielle peuvent être à base d'un même matériau. Cela rend plus aisée la libération finale du premier élément suspendu et du deuxième élément suspendu.

Dans ce cas, et dans ce lui où l'on effectue un remplissage des premières tranchées par un matériau appelé « matériau sacrificiel », le matériau sacrificiel peut être le même que celui de la première zone sacrificielle et de la deuxième zone sacrificielle.

La couche de liaison peut avantageusement en outre servir de zone d'arrêt de gravure lors de la formation des deuxièmes tranchées autour du deuxième élément suspendu.

Selon une possibilité de mise en oeuvre, une cavité peut être pratiquée sur une face du deuxième substrat le report du deuxième substrat sur le premier substrat étant réalisé de telle sorte que cette cavité est disposée en regard d'une région du premier substrat dans laquelle le premier élément et le deuxième élément sont destinés à être formés.

Une cavité dans le deuxième substrat peut notamment permettre d'accroitre l'espace dans lequel le premier élément suspendu et le deuxième élément suspendu peuvent se mouvoir.

Selon une possibilité de mise en oeuvre du procédé pour laquelle le trou réalisé est un trou borgne, après report du deuxième substrat sur le premier substrat et préalablement à la formation du deuxième élément suspendu, un amincissement du premier substrat, de manière à retirer une épaisseur située du côté d'une deuxième face du premier substrat opposée à ladite première face peut être effectué. Cet amincissement peut être poursuivi jusqu'à atteindre la première zone sacrificielle.

Dans ce cas, la première zone sacrificielle peut servir de zone d'arrêt de gravure. L'amincissement du premier substrat permet d'ajuster l'épaisseur du deuxième élément suspendu formé dans l'épaisseur du premier substrat.

Selon une possibilité de mise en oeuvre du procédé, la couche donnée peut être est à base d'un matériau semi-conducteur, avantageusement du Si monocristallin.

Selon une possibilité de mise en oeuvre du procédé, le report de ladite couche donnée peut comprendre des étapes de :
- report d'un autre substrat comprenant cette couche donnée ou recouvert par cette couche donnée, puis
- retrait d'une épaisseur de cet autre substrat de manière à conserver la couche donnée.

Le retrait de cette épaisseur de cet autre substrat peut être réalisé à l'aide d'un procédé de type smartcut™

Le premier élément suspendu peut être prévu avec une largeur donnée tandis que le trou peut avoir une section mesurée dans la même direction que la largeur donnée qui est supérieure à la largeur donnée afin de pouvoir complètement libérer le premier élément.

Selon une possibilité de mise en oeuvre le premier substrat est un substrat massif encore appelé substrat « bulk ».

Dans ce cas, on peut avantageusement se prémunir de l'utilisation d'un substrat de type semi-conducteur sur isolant plus onéreux.

Avantageusement, le premier substrat est du silicium monocristallin.

De même, le deuxième substrat peut également être un substrat massif ou bulk. Avantageusement, le deuxième substrat est du silicium monocristallin.

La présente invention concerne également un procédé de fabrication d'un dispositif MEMS et/ou NEMS comprenant la réalisation d'une structure selon un procédé tel que défini précédemment.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A à 1K sont des représentations schématiques de différentes étapes d'un procédé de réalisation d'une structure à partie active dotée d'éléments suspendus d'épaisseurs différentes selon un premier mode de réalisation ;
- les figures 2A à 2C sont des représentations schématiques de différentes étapes de réalisation d'une variante du procédé du premier mode de réalisation ;
- les figures 3A à 3H sont des représentations schématiques de différentes étapes de réalisation d'un deuxième mode de réalisation ;
- les figures 4A à 4C sont des représentations schématiques de différentes étapes de réalisation d'une autre variante du procédé selon le deuxième mode de réalisation ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure comme par exemple « latéral », « supérieure », « inférieure », « sous », « sur », s'appliquent en considérant que la structure est orientée de la façon illustrée dans les figures.

### EXPOSÉ DÉTAILLÉ DE MODES DE RÉALISATION PARTICULIERS

Dans la présente demande, on désigne par " partie active " d'une structure MEMS et/ou NEMS une partie suspendue, susceptible de se déplacer et/ou de se déformer sous l'effet d'une action extérieure qui peut être par exemple mécanique, et/ou électrique, et/ou magnétique.

Un élément qui sera nommé "premier élément suspendu" peut former une partie NEMS d'une structure MEMS&NEMS, tandis qu'un autre élément qui sera désigné comme "deuxième élément suspendu" peut former une partie MEMS de la structure MEMS&NEMS.

Dans les procédés décrits, seuls un premier élément suspendu et un deuxième élément suspendu sont formés à des fins de simplicité. Cependant les procédés selon l'invention permettent de réaliser un ou plusieurs premiers éléments suspendus et un ou plusieurs deuxièmes éléments suspendus.

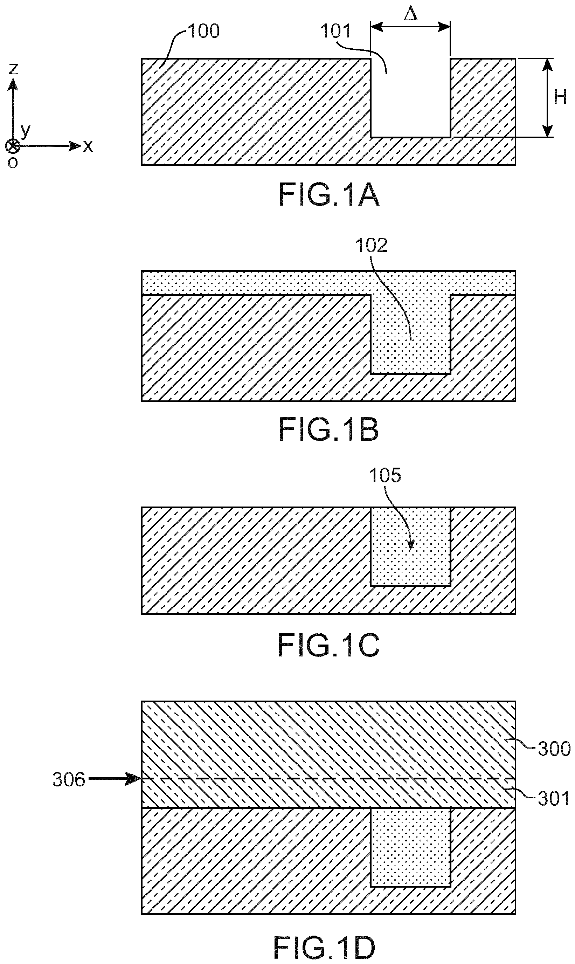

Un premier exemple de procédé de réalisation d'une structure comportant une partie active munie de zones d'épaisseurs différentes va à présent être donné en liaison avec les figures 1A à 1K.

Un matériau de départ de ce procédé peut être un premier substrat 100, en particulier un substrat massif (« bulk » selon la terminologie anglo-saxonne) qui peut être formé d'un matériau semi-conducteur tel que du Si, ou par exemple à base de Ge ou de SiGe ou de GaN ou de SiC, et dans lequel on pratique au moins un trou 101 (figure 1A). Le trou 101 peut être effectué par exemple par gravure anisotrope sèche de type DRIE (pour « Deep Reactive Ion Etching ») à travers une première face du premier substrat 100. Le trou 101 peut être formé avec une profondeur encore appelée hauteur H (mesurée parallèlement à un axe z d'un repère orthogonal [0 ;x ;y ;z] sur la figure 1A) comprise par exemple entre plusieurs micromètres et plusieurs dizaines de micromètres, et une dimension critique encore appelée largeur Δ (mesurée parallèlement au plan [0 ;x ;y] du repère orthogonal [0 ;x ;y ;z]) comprise par exemple entre plusieurs dizaines de nanomètres et plusieurs micromètres.

Ensuite, on effectue un remplissage du trou 101 par un matériau 102 destiné à former un matériau d'arrêt de gravure et un matériau sacrificiel au cours du procédé (figure 1B). Le matériau 102 de remplissage est de préférence un matériau choisi de manière à pouvoir être gravé de manière sélective vis-à-vis du matériau du premier substrat 100. Le matériau 102 peut être, par exemple, un matériau diélectrique tel que du SiO₂ Dans ce cas, le remplissage de matériau 102 peut être réalisé par exemple par oxydation des parois et du fond du trou 101 ou par un dépôt d'oxyde qui peut être conforme. Le remplissage peut être réalisé de sorte que le matériau 102 dépasse de l'embouchure du trou 101 et recouvre une face dite « supérieure » du premier substrat 100. Dans ce cas, un retrait du matériau 102 dans une zone située sur la face supérieure et au-delà de l'embouchure du trou 101 est réalisé, par exemple par le biais d'une planarisation de type CMP (pour « chemical mechanical planarization ») avec arrêt sur la face supérieure du premier substrat 100 (figure 1C). Le trou 101 rempli de matériau 102 constitue une zone 105 destinée à former une zone d'arrêt de gravure et une zone sacrificielle destinée à être retirée ultérieurement.

Ensuite, on peut préparer la face supérieure du premier substrat 100 au collage ou à un report sur une couche 301 dans laquelle le premier élément suspendu et une partie du deuxième élément suspendu sont destinés à être réalisés. Cette préparation peut être effectuée par exemple à l'aide d'un traitement plasma.

La couche 301 reportée peut être semi-conductrice et en particulier une couche superficielle d'un autre substrat 300 destinée à être détachée de cet autre substrat 300. L'épaisseur de la couche 301 peut être comprise entre plusieurs nanomètres et plusieurs dizaines de nanomètres, par exemple de l'ordre de 100 nm, mais le report permet éventuellement d'assembler des couches d'épaisseurs plus importantes.

On assemble ainsi tout d'abord la couche 301 de cet autre substrat 300 sur la face supérieure du premier substrat 100, par exemple par collage moléculaire (figure 1D). Un tel procédé ne nécessite pas obligatoirement d'alignement.

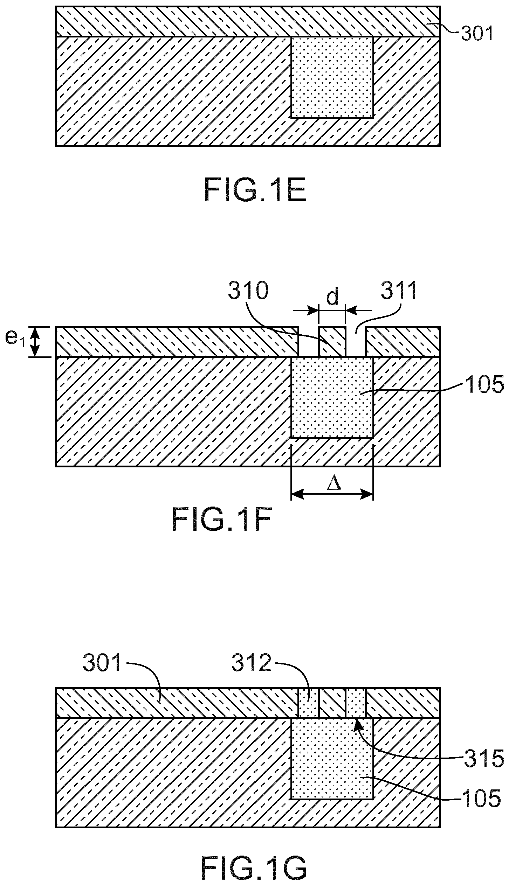

Puis, on retire au moins une épaisseur de l'autre substrat 300. Ce retrait peut être réalisé par un procédé de détachement (« splitting » selon la terminologie anglo-saxonne) dans lequel, après avoir créé une zone longitudinale de fragilisation 306 dans le substrat 300 qui sépare une partie appelée « poignée » et la couche superficielle 301, on détache la poignée de manière à ne conserver que la couche superficielle 301. La zone de fragilisation 306 peut être créée par exemple par le biais d'une implantation de H₂ réalisée éventuellement avant assemblage avec le premier substrat 100. L'étape de détachement (figure 1E) peut être précédée d'une étape de recuit.

On définit ensuite le premier élément suspendu 310 dans la couche superficielle 301. Pour cela, on peut effectuer une étape de lithographie de la couche 301 pour délimiter une zone par exemple en forme d'une poutre de largeur d (mesurée parallèlement au plan [0 ;x ;y] d'un repère orthogonal [0 ;x ;y ;z] sur la figure 1F) comprise par exemple entre 100 nm et 1 µm de large, d'épaisseur e₁ (mesurée parallèlement à un axe z du repère orthogonal [0 ;x ;y ;z]) comprise par exemple entre 100 nm et 1 µm et une longueur comprise entre 100 nm µm et 100 µm, qui peut être destinée à réaliser une jauge de contrainte. Le premier élément suspendu 310 peut être prévu avec une largeur d inférieure à la section Δ du trou 101 rempli de matériau 102. Cette configuration est avantageuse car la couche 102 sert de couche de protection du premier élément et de couche d'arrêt de gravure lors de la définition du deuxième élément suspendu. La gravure de la couche 301 est réalisée, de sorte à former des tranchées 311 autour du premier élément suspendu 310 et à s'arrêter sur la première zone sacrificielle 105.

Ces tranchées 311 peuvent être remplies ensuite d'un matériau 312 dit « deuxième matériau » et qui peut être avantageusement le même que celui 102 de remplissage du trou 101 formé dans le premier substrat 100 (figure 1G). Le matériau 312 de remplissage des tranchées 311 est de préférence un matériau choisi de manière à pouvoir être gravé de manière sélective vis-à-vis du matériau du premier substrat 100 et de la couche 301. Le matériau 312 de remplissage des tranchées 311, par exemple du SiO₂ forme une autre zone sacrificielle 315 autour du premier élément suspendu 310 qui se trouve en contact avec la zone sacrificielle 105 et qui est également destinée à être retirée ultérieurement.

Ensuite, on assemble le premier substrat 100 avec un substrat 200 appelé deuxième substrat. Le deuxième substrat 200 peut être en particulier un substrat massif en matériau semi-conducteur tel que du Si, ou par exemple à base de Ge ou de SiGe ou de GaN ou de SiC, ou à base d'un autre matériau tel que par exemple du verre.

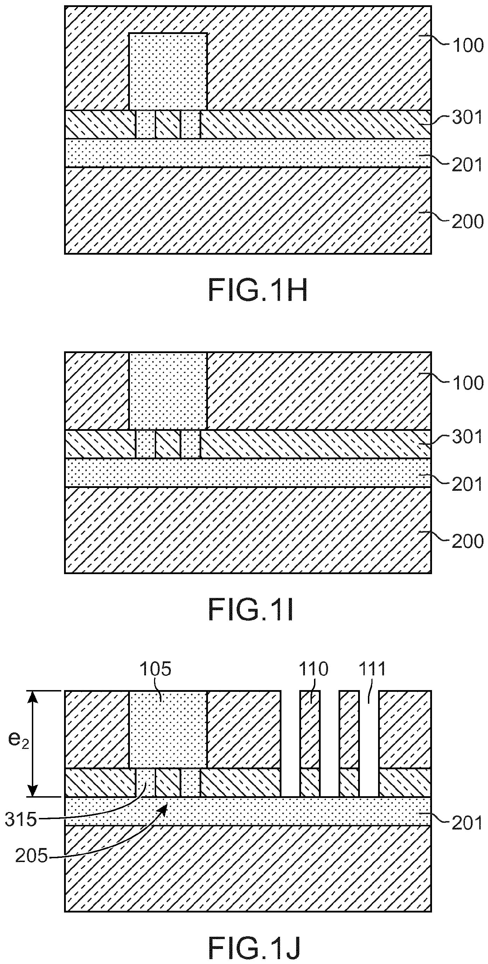

Le deuxième substrat 200 est, selon un exemple de réalisation particulier, recouvert d'une couche 201 dite « de liaison » permettant le collage ou de favoriser l'adhésion au premier substrat 100 (figure 1H). Un report par exemple par collage moléculaire ou collage anodique ou collage eutectique peut être effectué.

Ensuite, on peut effectuer un amincissement du premier substrat 100 de manière à réaliser un retrait de son épaisseur au niveau de sa face inférieure, c'est-à-dire la face opposée à la face supérieure du premier substrat 100 contre laquelle la couche de liaison 201 du deuxième substrat 200 est disposée. Cet amincissement peut être mis en oeuvre de manière dévoiler la zone sacrificielle 105 réalisée dans l'épaisseur du premier substrat 100, la zone sacrificielle 105 pouvant alors marquer l'arrêt de la gravure (figure 1I). L'amincissement est par exemple réalisé par abrasion en face arrière ("back-grinding" selon la terminologie anglo-saxonne), puis polissage mécano-chimique.

Cet amincissement permet de définir l'épaisseur du deuxième élément suspendu correspondant par exemple à la partie MEMS dans le cas de structures dites MEMS&NEMS.

On définit ensuite le deuxième élément suspendu 110 dans le premier substrat et la couche superficielle 301. Pour cela, on peut effectuer une étape de lithographie pour délimiter une zone par exemple, sous forme de plusieurs poutres de largeur comprises par exemple entre 0.1 µm et 100 µm, d'épaisseur e₂ (mesurée parallèlement à un axe z d'un repère orthogonal [0 ;x ;y ;z] sur la figure 1J) comprise par exemple entre 10 µm et 100 µm et une longueur comprise entre 10 µm et 100 µm.

La gravure du premier substrat 100 et de la couche 301 est réalisée, de sorte que des tranchées 111 dites deuxièmes tranchées sont formées autour du deuxième élément suspendu, par exemple par une technique de gravure ionique profonde ou DRIE (pour « Deep Reactive Ion etching »). Le fond dévoile la couche de liaison 201 qui peut ici servir de couche d'arrêt de gravure.

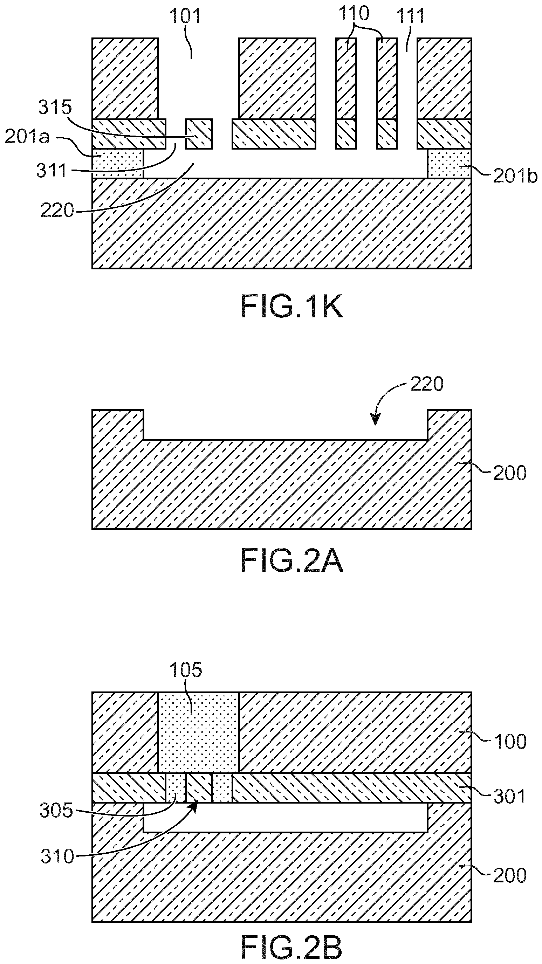

On effectue ensuite une libération du premier élément suspendu 310 par retrait des zones sacrificielles 105 et 315 situées autour. Une autre zone sacrificielle 205 correspondant à une portion de la couche superficielle 201 qui s'étend en regard du premier élément 310 et du deuxième élément suspendu 110 est également retirée. Le retrait de cette autre zone sacrificielle 205 permet la libération du deuxième élément suspendu 110. Le retrait des zones sacrificielles a pour effet de découvrir les tranchées 111, 311, et le trou 101 (figure 1K).

Dans un cas où les zones sacrificielles 105, 315, 205 sont formées du même matériau, le retrait est facilité. Le matériau des zones sacrificielles est de préférence également prévu de manière à pouvoir être gravé de manière sélective vis-à-vis du ou des matériaux des substrats 100, 200 et de la couche 301. Dans le cas par exemple où les zones sacrificielles 105, 315, 205 sont à base de SiO₂, la libération peut être conduite par gravure à l'aide d'acide fluorhydrique.

A l'issue de cette libération, des portions de la couche de liaison 201 peuvent être conservées de manière à former des piliers 201a, 201b assurant le maintien de l'assemblage entre le premier substrat 100 et le deuxième substrat 200. Ces piliers 201a, 201b sont répartis autour du premier élément 310 et du deuxième élément 110 suspendus.

Une variante du premier exemple de procédé est donnée sur les figures 2A-2C. Pour cette variante, le deuxième substrat 200 comporte une cavité 220 pratiquée sur sa face supérieure (figure 2A) et qui, lorsque l'on effectue ensuite le report du deuxième substrat 200 sur le premier substrat 100, est placée en regard du premier élément suspendu 310 et d'une zone dans laquelle le deuxième élément suspendu 110 est destiné à être réalisé (figure 2B).

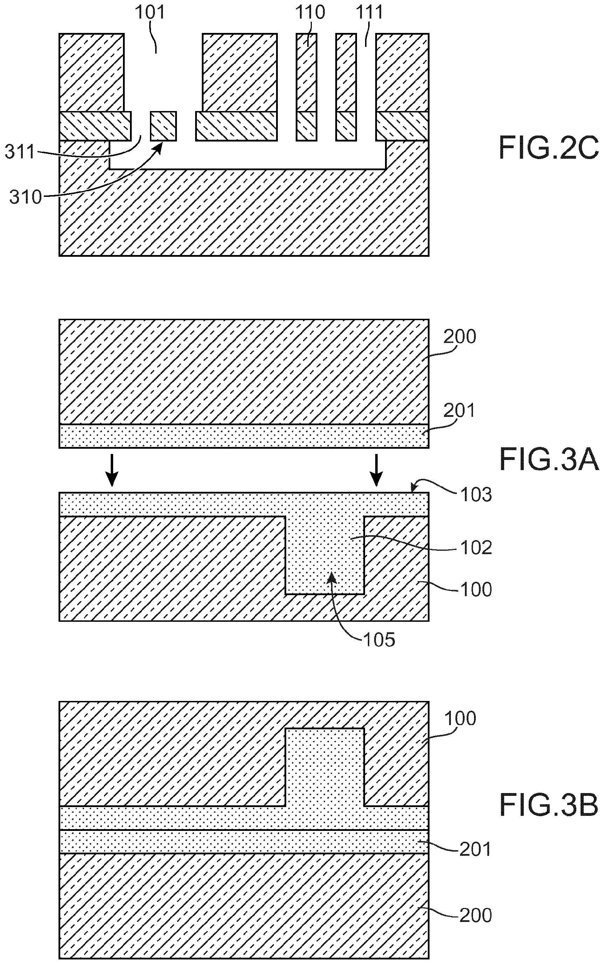

On structure ensuite le deuxième élément suspendu 110 dans le premier substrat 100 et la couche superficielle 301. Puis, on effectue la libération du premier élément suspendu 310 par retrait des zones sacrificielles 105 et 315 situées autour (figure 2C). Avec une telle cavité 220, une gravure d'une zone sacrificielle située sous les éléments suspendus et pratiquée dans une couche de liaison n'est pas nécessaire, une étape de libération du deuxième élément suspendu n'étant alors pas non plus nécessaire.

Un autre exemple de réalisation est donné sur les figures 3A-3H.

Pour cet autre mode de réalisation, après avoir formé le trou 101 dans le premier substrat 100, on remplit ce trou 101 à l'aide du matériau 102, par exemple du SiO₂ de sorte que le matériau 102 dépasse de l'embouchure du trou 101 et qu'une couche 103 de matériau 102 recouvre la face supérieure du premier substrat 100.

Ensuite, on assemble le premier substrat 100 avec le deuxième substrat 200 (figures 3A et 3B), en mettant la couche 103 de matériau 102 affleurant sur le premier substrat 100 en contact avec la couche 201 de liaison du deuxième substrat 200. 100. Un collage de type oxyde sur oxyde peut être par exemple réalisé lorsque le matériau 102 et la couche de liaison 201 sont à base de SiO₂

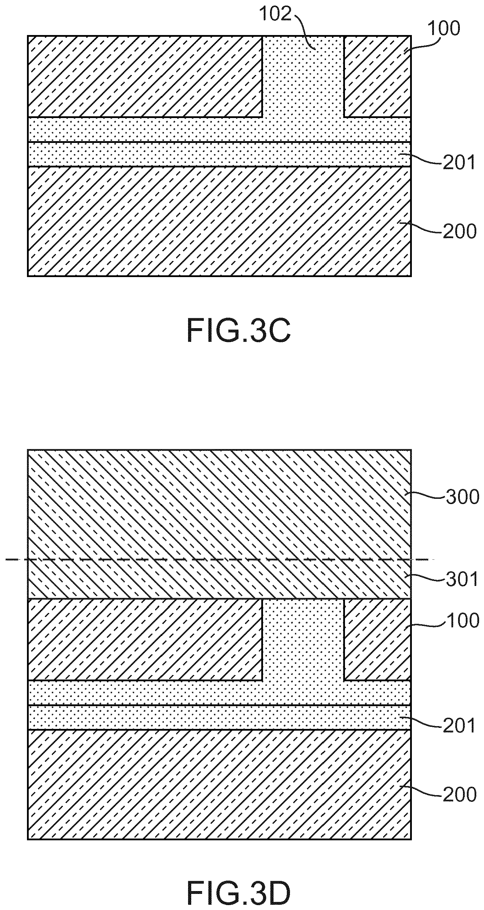

Puis, on effectue un amincissement du premier substrat 100 de manière à retirer une épaisseur située au niveau de sa face inférieure, afin d'ajuster l'épaisseur e₂ de la deuxième structure suspendue qui est destinée à être réalisée ultérieurement (figure 3C). L'amincissement est effectué par exemple par CMP jusqu'à atteindre la zone sacrificielle 105 qui sert alors de zone d'arrêt de gravure.

On effectue ensuite un report d'une couche 301 dans laquelle le premier élément suspendu et une partie du deuxième élément suspendu sont destinés à être formés (figure 3D). Cette couche 301 est par exemple la couche superficielle d'un autre substrat 300 semi-conducteur et est reportée sur la face inférieure du premier substrat 100, par exemple par collage moléculaire. Un alignement précis des substrats n'est alors pas nécessaire.

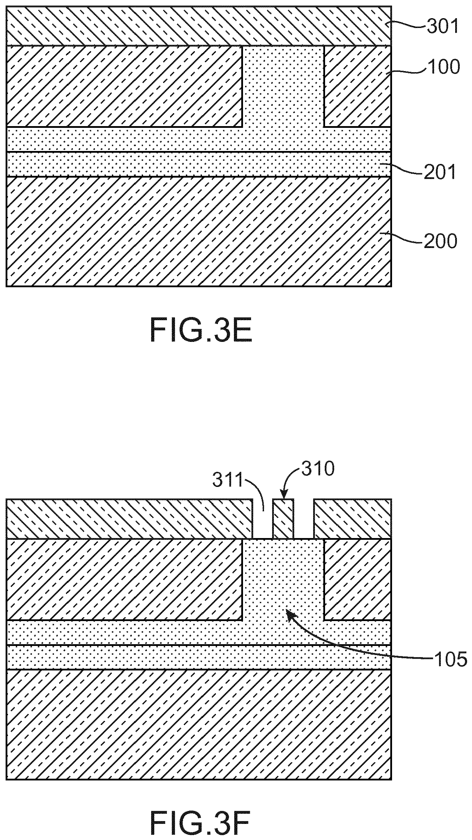

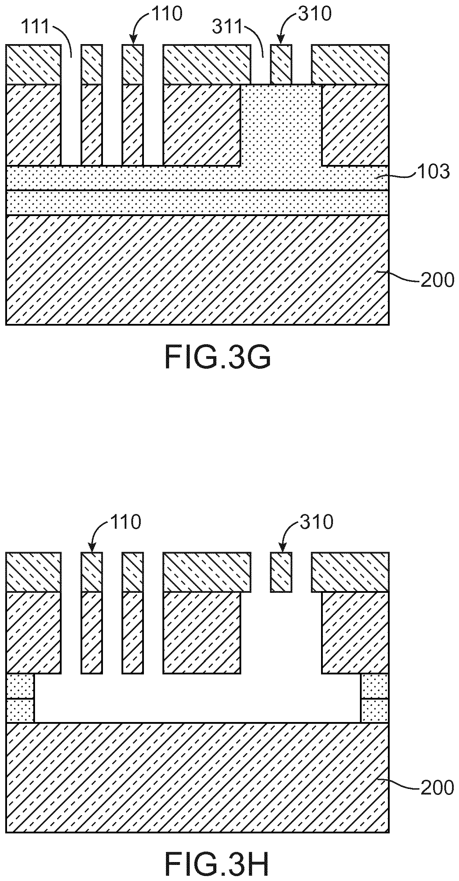

Puis, on effectue un amincissement de l'autre substrat 300 par exemple par un procédé de détachement tel que décrit précédemment, après avoir créé une zone longitudinale 306 de fragilisation dans l'autre substrat 300 et réalisé un recuit (figure 3E). On définit ensuite le premier élément suspendu 310 dans la couche superficielle 301 (figure 3F) entouré de premières tranchées 311 dont le fond dévoile la zone sacrificielle 105. On définit également le deuxième élément suspendu 110 en partie dans la couche superficielle 301 et en partie dans le premier substrat 101 (figure 3G), de sorte que le deuxième élément suspendu 110 est entouré de deuxièmes tranchées 111. Le fond des deuxièmes tranchées 111 dévoile la couche 103 de matériau 102 située entre les deux substrats 100 et 200.

On effectue ensuite une libération du premier élément suspendu 310 et du deuxième élément suspendu 110 par retrait du matériau 102 de remplissage du trou 101 et par retrait d'une portion du matériau 102 et de la couche de liaison 201 disposées entre le premier substrat 100 et le deuxième substrat 200 et sur laquelle repose la deuxième structure 110 (figure 3H).

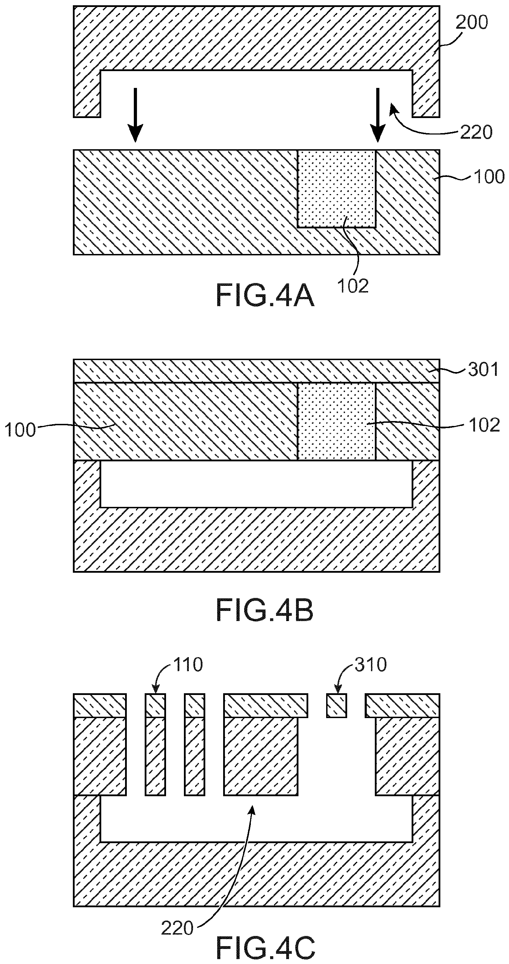

Une variante de l'exemple de procédé qui vient d'être décrit est donnée sur les figures 4A-4C.

Pour cette variante, après avoir formé le trou 101 dans le premier substrat 100 et que l'on a rempli de matériau 102, on effectue ensuite le report du deuxième substrat 200 sur le premier substrat 100 (figures 4A et 4B). Cette fois, le deuxième substrat 200 comporte une cavité 220 pratiquée sur sa face supérieure. La cavité 220 est disposée notamment en regard d'une zone du premier substrat 100 dans laquelle le deuxième élément 110 suspendu est destiné à être réalisé, ainsi qu'en regard de la zone sacrificielle 105 formée par le trou rempli de matériau 102.

On forme ensuite le deuxième élément suspendu 110 dans le premier substrat 110 et la couche superficielle 301.

Puis, on effectue la libération du premier élément suspendu 310 par retrait de la zone sacrificielle 105 et éventuellement d'autres zones sacrificielles autour (figure 4C).

Grâce au procédé selon l'invention, il est possible de ne pas recourir à l'utilisation de substrat semi-conducteur sur isolant en particulier de type SOI (pour « silicon on insulator ») et de ne pas effectuer d'épitaxie. Un gain en coût et en temps est alors obtenu.

Il est aussi possible de réaliser une co-intégration CMOS en trois dimensions. Dans ce cas, le deuxième substrat peut être par exemple un substrat doté de composants électroniques par exemple réalisés en technologie CMOS.

Le procédé selon l'invention est particulièrement adapté à la réalisation de capteurs et d'actionneurs microélectromécaniques et/ou de systèmes nanoélectromécaniques, par exemple tels que des capteurs inertiels des accéléromètres, gyroscopes, magnétomètres, capteurs de pression, microphones.

## Revendications

1. Procédé de réalisation d'une structure comportant une partie active comprenant au moins un premier élément suspendu (310) et un deuxième élément suspendu (110) d'épaisseurs différentes,
le procédé comprenant des étapes consistant à :
- Former dans un premier substrat (100) une première zone sacrificielle (105),
- Reporter sur une première face du premier substrat une couche donnée (301) s'étendant au moins sur la première zone sacrificielle,
- Définir dans ladite couche donnée (301) au moins un premier élément suspendu (310) sur la première zone sacrificielle (105), par formation d'une ou plusieurs premières tranchées (311) dans la couche donnée ayant un fond dévoilant la première zone sacrificielle (105),
- Définir au moins un deuxième élément suspendu (110) par formation d'une ou plusieurs deuxièmes tranchées (111) dans le premier substrat et à travers ladite couche donnée (301), le deuxième élément suspendu ayant une épaisseur (e₂) supérieure à l'épaisseur (e₁) du premier élément suspendu,
- Libérer au moins le premier élément suspendu (310) par retrait d'au moins la première zone sacrificielle (105).

2. Procédé selon la revendication 1, comprenant en outre après la formation de la première zone sacrificielle (105), une étape consistant à reporter un deuxième substrat (200) soit sur une deuxième face du premier substrat (100), soit sur la couche donnée (301).

3. Procédé selon la revendication 2, dans lequel on réalise dans cet ordre préalablement à la définition du deuxième élément suspendu :
- l'étape consistant à reporter la couche donnée (301) sur le premier substrat (100),
- puis l'étape consistant à définir le premier élément suspendu (310) dans ladite couche donnée (301),
- puis l'étape consistant à reporter le deuxième substrat (200) sur la couche donnée (301).

4. Procédé selon la revendication 3, dans lequel entre l'étape consistant à définir le premier élément suspendu (310) dans ladite couche donnée (301) et l'étape consistant à reporter un deuxième substrat (200) sur la couche donnée, on effectue un remplissage des premières tranchées (311) par un matériau sacrificiel (312), les premières tranchées remplies du matériau sacrificiel (312) formant une autre zone sacrificielle (315), l'étape de libération du premier élément (310) comprenant le retrait de ladite autre zone sacrificielle.

5. Procédé selon la revendication 2, dans lequel préalablement à la définition du deuxième élément suspendu on réalise dans cet ordre :
- l'étape consistant à reporter le deuxième substrat (200) sur le premier substrat (100),
- puis l'étape consistant à reporter ladite couche donnée (301) sur le premier substrat (100),
- puis l'étape consistant à définir le premier élément suspendu (310) dans ladite couche donnée (301).

6. Procédé selon l'une des revendications 2 à 5, dans lequel le deuxième substrat (200) est assemblé au premier substrat (100) ou à la couche donnée (301) par le biais d'une couche de liaison (201) comportant au moins une portion disposée en regard du premier élément suspendu et formant une deuxième zone sacrificielle (205) en regard de laquelle le deuxième élément suspendu (110) est destiné à être formé, la libération ultérieure du premier élément suspendu (310) comprenant le retrait de ladite deuxième zone sacrificielle (205) afin de libérer également le deuxième élément suspendu.

7. Procédé selon la revendication 6, dans lequel les premières et deuxièmes zones sacrificielles (105, 315, 205) sont à base d'un même matériau.

8. Procédé selon la revendication 6 ou 7, dans lequel la formation des deuxièmes tranchées (111) est formée par gravure prolongée jusqu'à atteindre la couche de liaison (201), la couche de liaison servant de zone d'arrêt de gravure.

9. Procédé selon l'une des revendications 2 à 8, dans lequel une cavité (220) est pratiquée sur une face du deuxième substrat, le report du deuxième substrat (200) sur le premier substrat (100) ou la couche donnée (301), étant réalisé de telle sorte que la cavité (220) est disposée en regard d'une région du premier substrat (100) et/ou de la couche donnée dans laquelle, le premier élément et le deuxième élément sont destinés à être formés.

10. Procédé selon l'une des revendications 2 à 9, dans lequel la première zone sacrificielle est formée par réalisation d'au moins un trou (101) borgne à travers respectivement la première ou la deuxième face du premier substrat puis remplissage du trou par au moins un premier matériau (102), le procédé comprenant en outre, après l'étape de report du deuxième substrat (200) respectivement sur la couche donnée ou sur le premier substrat (100) et préalablement à la formation du deuxième élément suspendu (110), une étape d'amincissement respectivement de la deuxième face ou de la première face du premier substrat (100) de manière à retirer une épaisseur de premier substrat située du côté opposé à la face à partir de laquelle est réalisée le trou (101) borgne, l'amincissement étant poursuivi jusqu'à atteindre la première zone sacrificielle (105), la première zone sacrificielle (105) servant alors de zone d'arrêt de gravure.

11. Procédé selon l'une des revendications 1 à 10, dans lequel l'étape de report de ladite couche donnée (301) comprend des étapes de :
- report d'un autre substrat (300) comprenant cette couche donnée (301) ou recouvert par cette couche donnée (301),
- retrait partiel de cet autre substrat (300) de manière à conserver la couche donnée (301) sur le premier substrat.

12. Procédé selon la revendication 11, dans lequel le report se fait par une technique de collage direct.

13. Procédé selon l'une des revendications 1 à 12, dans lequel la couche donnée (301) est à base d'un matériau semi-conducteur avantageusement du silicium monocristallin.

14. Procédé selon l'une des revendications 1 à 13 dans lequel le premier élément suspendu (310) a une largeur donnée, le trou (101) ayant une section supérieure à la largeur donnée.

15. Procédé selon l'une des revendications 1 à 14, dans lequel le premier substrat est un substrat semi-conducteur avantageusement du silicium monocristallin.

16. Procédé de fabrication d'un dispositif MEMS et/ou NEMS comprenant la réalisation d'une structure selon un procédé de réalisation suivant l'une des revendications 1 à 15.

## Patentansprüche

1. Verfahren zur Herstellung einer Struktur, umfassend einen aktiven Teil, umfassend wenigstens ein erstes Hängeelement (310) und ein zweite Hängeelement (110) mit unterschiedlichen Dicken,
wobei das Verfahren die folgenden Schritte umfasst:
- Bilden, in einem ersten Substrat (100), einer ersten Opferzone (105),
- Anbringen, auf einer ersten Fläche des ersten Substrats, einer gegebenen Schicht (301), die sich wenigstens auf der ersten Opferzone erstreckt,
- Definieren, in der gegebenen Schicht (301), wenigstens eines ersten Hängeelements (310) auf der ersten Opferzone (105) durch Bilden eines oder mehrerer erster Gräben (311) in der gegebenen Schicht mit einem Boden, der die erste Opferzone (105) freilegt,
- Definieren wenigstens eines zweiten Hängeelements (110) durch Bilden eines oder mehrerer zweiter Gräben (111) in dem ersten Substrat und durch die gegebene Schicht (301) hindurch, wobei das zweite Hängeelement eine Dicke (e₂) hat, die größer ist als die Dicke (e₁) des ersten Hängeelements,
- Freilegen wenigstens des ersten Hängeelements (310) durch Entfernen wenigstens der ersten Opferzone (105).

2. Verfahren nach Anspruch 1, ferner umfassend, nach der Bildung der ersten Opferzone (105), einen Schritt des Anbringens eines zweiten Substrats (200) entweder auf einer zweiten Fläche des ersten Substrats (100) oder auf der gegebenen Schicht (301).

3. Verfahren nach Anspruch 2, wobei man vor der Definition des zweiten Hängeelements in dieser Reihenfolge Folgendes ausführt:
- den Schritt des Anbringens der gegebenen Schicht (301) an dem ersten Substrat (100),
- dann den Schritt des Definierens des ersten Hängeelements (310) in der gegebenen Schicht (301),
- dann den Schritt des Anbringens des zweiten Substrats (200) an der gegebenen Schicht (301).

4. Verfahren nach Anspruch 3, wobei man zwischen dem Schritt des Definierens des ersten Hängeelements (310) in der gegebenen Schicht (301) und dem Schritt des Anbringens eines zweiten Substrats (200) an der gegebenen Schicht ein Auffüllen der ersten Gräben (311) mit einem Opfermaterial (312) durchführt, wobei die mit dem Opfermaterial (312) gefüllten ersten Gräben eine weitere Opferzone (315) bilden, wobei der Schritt des Freilegens des ersten Elements (310) das Entfernen der weiteren Opferzone umfasst.

5. Verfahren nach Anspruch 2, bei dem man vor der Definition des zweiten Hängeelements in dieser Reihenfolge Folgendes durchführt:
- den Schritt des Anbringens des zweiten Substrats (200) an dem ersten Substrat (100),
- dann den Schritt des Anbringens der gegebenen Schicht (301) an dem ersten Substrat (100),
- dann den Schritt des Definierens des ersten Hängeelements (310) in der gegebenen Schicht (301).

6. Verfahren nach einem der Ansprüche 2 bis 5, bei dem das zweite Substrat (200) mit dem ersten Substrat (100) oder mit der gegebenen Schicht (301) mittels einer Verbindungsschicht (201) zusammengefügt ist, die wenigstens einen Bereich umfasst, der gegenüber dem ersten Hängeelement angeordnet ist und eine zweite Opferzone (205) bildet, gegenüber der das zweite Hängeelement (110) gebildet werden soll, wobei die spätere Freilegung des ersten Hängeelements (310) das Entfernen der zweiten Opferzone (205) umfasst, um auch das zweite Hängeelement freizulegen.

7. Verfahren nach Anspruch 6, wobei die erste und die zweite Opferzone (105, 315, 205) auf Basis ein und desselben Materials gefertigt sind.

8. Verfahren nach Anspruch 6 oder 7, wobei das Bilden der zweiten Gräben (111) durch verlängertes Ätzen erfolgt, bis die Verbindungsschicht (201) erreicht wird, wobei die Verbindungsschicht als Ätzstoppzone dient.

9. Verfahren nach einem der Ansprüche 2 bis 8, wobei ein Hohlraum (220) an einer Fläche des zweiten Substrats vorgesehen ist, wobei das Anbringen des zweiten Substrats (200) an dem ersten Substrat (100) oder der gegebenen Schicht (301) derart erfolgt, dass der Hohlraum (220) gegenüber einer Region des ersten Substrats (100) und/oder der gegebenen Schicht angeordnet ist, in der das erste Element und das zweite Element gebildet werden sollen.

10. Verfahren nach einem der Ansprüche 2 bis 9, wobei die erste Opferzone durch Realisieren wenigstens eines Sacklochs (101) durch die erste beziehungsweise die zweite Fläche des ersten Substrats und anschließendes Auffüllen des Lochs mit wenigstens einem erstem Material (102) gebildet wird, wobei das Verfahren ferner nach dem Schritt des Anbringens des zweiten Substrats (200) an der gegebenen Schicht beziehungsweise an dem ersten Substrat (100) und vor der Bildung des zweiten Hängeelements (110) einen Schritt des Abdünnens der zweiten Fläche beziehungsweise der ersten Fläche des ersten Substrats (100) derart umfasst, dass eine Dicke des ersten Substrats entfernt wird, die an der Seite entgegengesetzt zu der Fläche angeordnet ist, ausgehend von der das Sackloch (101) realisiert ist, wobei das Abdünnen fortgesetzt wird, bis die erste Opferzone (105) erreicht wird, wobei die erste Opferzone (105) somit als Ätzstoppzone dient.

11. Verfahren nach einem der Ansprüche 1 bis 10, wobei der Schritt des Anbringens der gegebenen Schicht (301) die folgenden Schritte umfasst:
- Anbringen eines weiteren Substrats (300), das diese gegebene Schicht (301) umfasst oder von dieser gegebenen Schicht (301) bedeckt ist,
- partielles Entfernen dieses weiteren Substrats (300) derart, dass die gegebene Schicht (301) auf dem ersten Substrat beibehalten wird.

12. Verfahren nach Anspruch 11, bei dem das Anbringen durch eine Direktklebetechnik erfolgt.

13. Verfahren nach einem der Ansprüche 1 bis 12, wobei die gegebene Schicht (301) auf Basis eines Halbleitermaterials gefertigt ist, vorzugsweise monokristallinem Silizium.

14. Verfahren nach einem der Ansprüche 1 bis 13, wobei das erste Hängeelement (310) eine gegebene Breite hat, wobei das Loch (101) einen Querschnitt hat, der größer als die gegebene Breite ist.

15. Verfahren nach einem der Ansprüche 1 bis 14, wobei das erste Substrat ein Halbleitersubstrat ist, vorzugsweise monokristallines Silizium.

16. Verfahren zur Herstellung einer MEMS und/oder NEMS-Vorrichtung, umfassend die Herstellung einer Struktur gemäß einem Herstellungsverfahren nach einem der Ansprüche 1 bis 15.

## Claims

1. A method for making a structure including an active part comprising at least one first suspended element (310) and a second suspended element (110) having different thicknesses,
the method comprising the steps of:
- forming, in a first substrate (100), a first sacrificial zone (105),
- transferring onto a first face of the first substrate a given layer (301) extending at least on the first sacrificial zone,
- defining in said given layer (301) at least one first suspended element (310) on the first sacrificial zone (105), by forming one or more first trenches (311) in the given layer having a bottom revealing the first sacrificial zone (105),
- defining at least one second suspended element (110) by forming one or more second trenches (111) in the first substrate and through said given layer (301), the second suspended element having a thickness (e₂) higher than the thickness (e₁) of the first suspended element,
- releasing at least the first suspended element (310) by removing at least the first sacrificial zone (105).

2. The method according to claim 1, further comprising, after forming the first sacrificial zone (105), a step of transferring a second substrate (200) either onto a second face of the first substrate (100), or on the given layer (301).

3. The method according to claim 2, wherein prior to defining the second suspended element, the following are made in this order:
- the step of transferring the given layer (301) onto the first substrate (100),
- and then the step of defining the first suspended element (310) in said given layer (301),
- and then the step of transferring the second substrate (200) onto the given layer (301).

4. The method according to claim 3, wherein between the step of defining the first suspended element (310) in said given layer (301) and the step of transferring a second substrate (200) onto the given layer, a filling of the first trenches (311) by a sacrificial material (312) is made, the first trenches filled with the sacrificial material (312) forming another sacrificial zone (315), the step of releasing the first element (310) comprising removing said other sacrificial zone.

5. The method according to claim 2, wherein prior to defining the second suspended element, the following are made in this order:
- the step of transferring the second substrate (200) onto the first substrate (100),
- and then the step of transferring said given layer (301) onto the first substrate (100),
- and then the step of defining the first suspended element (310) in said given layer (301).

6. The method according to any of the claims 2 to 5, wherein the second substrate (200) is assembled to the first substrate (100) or to the given layer (301) via a tie layer (201) including at least one portion provided facing the first suspended element and forming a second sacrificial zone (205) facing which the second suspended element (110) is intended to be formed, the subsequent release of the first suspended element (310) comprising removing said second sacrificial zone (205) in order to also release the second suspended element.

7. The method according to claim 6, wherein the first and second sacrificial zones (105, 315, 205) are based on a same material.

8. The method according to any of the claims 6 or 7, wherein the formation of the second trenches (111) is formed by prolonged etching until the tie layer (201) is reached, the tie layer forming as an etching stop zone.

9. The method according to any of the claims 2 to 8, wherein a cavity is provided on a face of the second substrate, the transfer of the second substrate onto the first substrate or the given layer being made such that the cavity is provided facing a region of the first substrate and/or of the given layer in which the first element and the second element are intended to be formed.

10. The method according to any of the claims 2 to 9, wherein the first sacrificial zone is formed by making at least one blind hole (101) through the first or the second face respectively of the first substrate and then filling the hole with at least one first material (102), the method further comprising, after the step of transferring the second substrate (200) respectively onto the given layer or onto the first substrate (100) and prior to forming the second suspended element (110), a step of thinning respectively the second face or the first face of the first substrate (100) so as to remove a thickness of the first substrate which is located on the side opposite to the face from which the blind hole (101) is made, the thinning being continued until the first sacrificial zone (105) is reached, the first sacrificial zone acting subsequently as an etching stop zone.

11. The method according to any of the claims 1 to 10, wherein the step of transferring said given layer (301) comprises steps of:
- transferring another substrate (300)comprising this given layer (301) or covered with this given layer (301),
- partially removing this other substrate (300) so as to preserve the given layer (301) on the first substrate.

12. The method according to claim 11, wherein the transfer is made by a direct bonding technique.

13. The method according to any of the claims 1 to 12, wherein the given layer is based on a semi-conductor material, advantageously single crystal silicon.

14. The method according to any of the claims 1 to 13, wherein the first suspended element (310) has a given width, the hole (101) having a cross-section higher than the given width.

15. The method according to any of the claims 1 to 14, wherein the first substrate is a semi-conductor substrate, advantageously single crystal silicon.

16. A method for manufacturing a MEMS and/or NEMS device comprising a method according to any of the claims 1 to 15.
